# EUROPEAN PATENT SPECIFICATION

(11) **EP 0 621 882 B1**
(45) Date of publication and mention of the grant of the patent: **07.07.1999**
(21) Application number: 93912383.2
(22) Date of filing: 30.12.1992
(51) Int. Cl.: C08J 3/20, D21H 13/14, D21H 13/50, B32B 27/00

(54) **PROCESS FOR MAKING FLUOROPOLYMER COMPOSITES**
VERFAHREN ZUR HERSTELLUNG VON VERBUNDWERKSTOFFEN AUS FLUOROPOLYMER
PROCEDE DE PRODUCTION DE COMPOSITES DE FLUOROPOLYMERE

(30) Priority: 16.01.1992 US 821567
(43) Date of publication of application: 02.11.1994
(73) Proprietor: E.I. DU PONT DE NEMOURS AND COMPANY, Wilmington Delaware 19898 (US)
(72) Inventor: DEAKYNE, Clifford, Karl, Wilmington, DE 19808 (US); WEEKS, Gregory, Paul, Hockessin, DE 19707 (US)
(74) Representative: Abitz, Walter, Dr.-Ing.
(86) International application number: US9211320
(87) International publication number: WO9314150

(56) References cited:
- EP-A- 0 028 729
- US-A- 4 769 109
- DATABASE WPIL Week 9147, 9 October 1991 Derwent Publications Ltd., London, GB; AN 91-343210

## Description

### Field of the Invention

A process for the production of composites containing reinforcing fiber and a fluoropolymer.

### Technical Background

Polymeric composites consisting of a matrix resin (including fluoropolymers) and a reinforcing fiber are well known in the art. By adding the fiber to the matrix resin certain properties of the resin alone are often improved. These properties can include creep resistance, tensile strength and modulus, and flexural strength and modulus. Generally speaking, the reinforcing fiber chosen has a higher tensile modulus and strength than the polymer alone. When a fluoropolymer is used as the matrix resin, as described herein, the resulting composite often has many of the attributes of fluoropolymers such as high temperature resistance and chemical resistance, which make such composites useful as parts, for example, for the chemical processing industry. It is the object of this invention to provide a method for the production of such fluoropolymer composites that exhibit improved properties.

U.S. Patents 4,414,356 and 4,163,742, issued to Michel and Mansure, respectively, describe a process for making tetrafluoroethylene copolymer-graphite fiber composite by mixing the polymer and fiber together in a slurry and then removing the water to obtain an intimate mixture of fiber and polymer. It is also known that fluoropolymers have very low surface energy and are difficult to wet, especially as fine particulates, in aqueous media. Accordingly, the current art depends on the extensive use of organic solvents and emulsifying agents (as in the case of fluoropolymer dispersions) to overcome this obstacle. The amount of "wetting and dispersing" agents in such a slurry according to the art can be comparable to the weight of fluoropolymer resin. These organic dispersion aides must be recovered or disposed as waste. It is highly desirable to find a method for intimately co-dispersing finely divided fluorocarbon and other thermoplastic resins in aqueous media, essentially without the need for solvents and dispersing agents.

### SUMMARY OF THE INVENTION

This invention involves a process for the production of a fluoropolymer-fiber composite, comprising: co-dispersing fluoropolymer film-like flakes having microfibrils extending from an irregular periphery with reinforcing fibers in an aqueous solution substantially free of other constituents to form a homogeneous slurry; feeding the slurry to a screen in a layer; removing water from the layer; drying the layer to form a self-supporting planar preform layer; preconsolidating said preform layer by heating said preform layer above the fluoropolymer melt temperature, then applying sufficient pressure normal to the plane of said preform layer to cause the fluoropolymer to flow to form a solid preconsolidated sheet; and cooling said sheet.

This invention involves the use of a "fluoropolymer" as the matrix resin in a polymer-fiber composite. By fluoropolymer is meant an organic polymer that contains at least about 10% fluorine by weight, preferably at least about 45% fluorine by weight, and it is especially preferred if the polymer is perfluorinated, i.e., contains essentially no hydrogen or halogen other than fluorine bound to carbon. The fluoropolymer preferably is converted from a pellet form to unique film-like flakes having microfibrils extending from an irregular periphery by means of a commercial disk refining process using a Sprout Waldron disk refiner.

The fibrous material used in the instant process may be any of a variety of fibers usually used for such purposes. Of course, the fiber must be stable under the process conditions, not decomposing oxidatively or thermally, or reacting with the fluoropolymer. Fibers often used for this purpose include, but are not limited to, glass, graphite (carbon), fluorinated graphite, aramid such as poly(p-phenyleneterephthtalamide), boron nitride, silicon carbide, polyester, and polyamide. Graphite and fluorinated graphite are preferred fibers, and fluorinated graphite is especially preferred.

The fibers may be in a variety of forms for the present process. Preferably, the fiber may simply be chopped fiber that is mixed with the aqueous dispersion.

As is well known to those skilled in the art, polymer-fiber composites with superior properties are produced when there is good adhesion between the polymer and the fiber. It is common in the art to use fibers that have been surface treated with materials to improve this adhesion, and the use of such coated fibers is contemplated herein. Such coated fibers are articles of commerce and individual manufacturers make recommendations as to which fiber (and coating) should be used with any particular polymer.

### Brief Description of the Drawings

Fig. 1 is a schematic elevation view in section of a disk refining apparatus useful for making the fluoropolymer flakes of this invention.

Fig. 2 is a photomicrograph of fluoropolymer flakes of this invention.

Figs. 3 and 3A are schematic illustrations of the wet-laying process of this invention.

### Detailed Description of the Preferred Embodiment

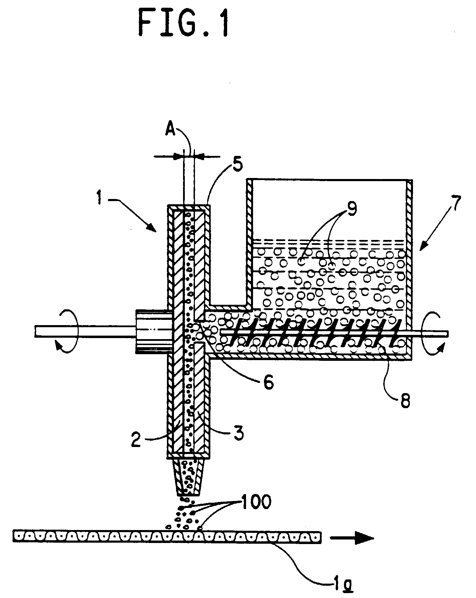

Referring to Fig. 1, a disk refiner 1 of the type manufactured by Sprout Waldron includes a driven groove plate 2 separated from a grooved plate 3 fixed to the disk refiner housing 5 by a distance A. A hole 6 through the center of plate 3 is in communication with the material feeder 7 which includes a driven screw 8. In operation, fluoropolymer pellets 9 are fed in a water slurry by means of screw 8 through opening 6 in plate 3 into the disk refiner. The pellets are discharged from the disk refiner in the form of a pulp composed of film-like flakes 100 where it is collected on screen 1a.

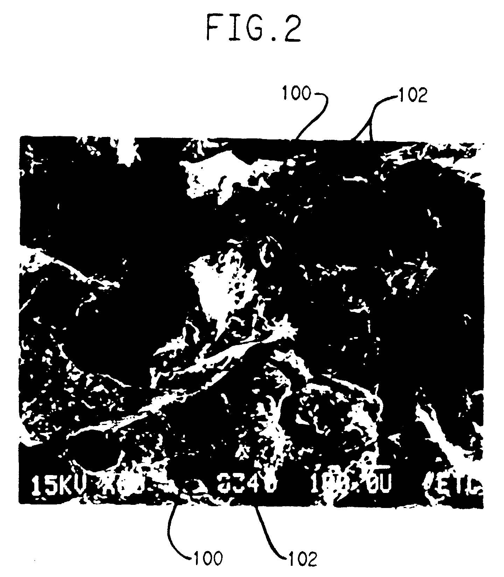

The film-like flakes 100 are shown in Fig. 2 to have an irregular periphery with microfibrils 102 extending from the periphery.

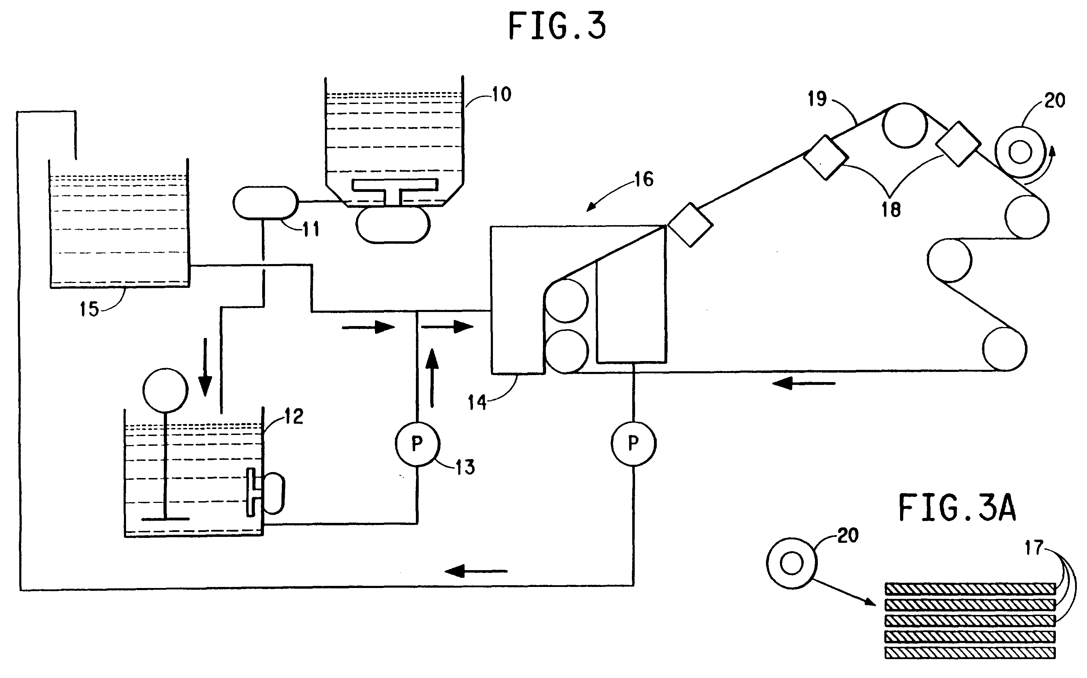

As best shown in Figs. 3 and 3A, the wet laying process of this invention utilizes paper-making equipment and generally includes a pulper 10, an agitated supply tank 12, the head box 14 of an inclined wire paper machine 16, a dewatering section 18, and a windup or driven spool 20. In operation, fibers and fluoropolymer fiber-like flakes are dispersed in water in pulper 10. The slurry is pumped via pump 11 from the pulper to an agitated supply tank 12. Feed stock from the supply tank is then pumped by means of pump 13 to the head box 14 where dilution water is added from tank 15 reducing stock consistency by a factor of 5. The slurry is drained through the wire in the usual manner and dewatered by passing over suction slots 18 in the dewatering section. The dewatered sheet 19 is then wound in damp form on driven spool 20. The porous sheet wound on the spool 20 is unwound in layers 17 and air dried as schematically shown in Fig. 3A.

| Equipment Description | | | |
|---|---|---|---|
| Element Number | Name | Model No. | Manufacturer |
| 10 | Pulper | GP 157 | Bird Machine Co., Inc. South Walpole, MA |
| | | | |
| 13 | Pump | 23B2-B | Gorman-Rupp Mansfield, OH |
| | | | |
| 16 | Papermaking Machine | Labor 23" | Neu Bruderhaus Reutlingen, W. Germany |

### Preconsolidation Process

An intermediate process prior to molding of the composite part has been found to provide a product with enhanced strength. Porous air dried sheets 17 are then heated to a temperature above the melt temperature of the fluoropolymer, then sufficient pressure is applied to cause the fluoropolymer to flow forming a solid preconsolidated sheet. The preconsolidated sheet is then cooled. This same sequence of events can be achieved on a continuous basis using a heating zone with a belt press or nip rolls. The process requires that the resin is heated above the melt, then pressure is applied causing the resin to flow forming a solid preconsolidated sheet and the preconsolidated sheet is cooled under pressure.

The preconsolidated sheet is then shaped into an article by subjecting the structure to heat and pressure for a sufficient amount of time to form it. The temperature, pressure and time required to do this will vary with such factors as the polymer, polymer viscosity, fiber configuration, and thickness. The polymer will usually be heated close to or above its glass transition or melting temperature, whichever is higher. It is possible to cause polymer flow below these temperatures, but it usually requires longer times and higher pressures. The pressure and time required is generally related to the polymer viscosity at the process temperature. The higher the viscosity, the higher the pressure and/or longer the time required. These factors are also affected by the fiber loading, with higher loadings generally requiring higher pressures and/or longer times. For any particular composition, these factors are readily determined by routine experimentation.

Pressure may be applied, for example, while the structure is in a die in a compression press, or if a flat sheet is desired, between the (heated) platens of a compression press. Other types of suitable equipment will be apparent to the art skilled.

The instant process yields composite articles superior to those of the prior art, particularly in regard to certain physical properties such as tensile strength. It is hypothesized that this occurs because of a more even distribution of the fluoropolymer in the composite, particularly in relationship to the fiber present.

In the following Examples, Teflon® PFA is a registered trademark of and available from E. I. du Pont de Nemours and Company, Wilmington, DE, and is a polymer containing about 99 mole percent tetrafluoroethylene and 1 mole percent perfluoro(propyl vinyl ether). Hercules AS 1815 is a graphite fiber available from Hercules, Inc., Wilmington, DE.

### EXAMPLES

### Example 1

Using a commercial Sprout Waldron 30.48 cm (12 inch) laboratory disk refiner, model 105A, substantially as described in Fig. 1 driven at 1800 rpm with a combination of grooved plates, the position of the plates set at a distance of 0.0254 mm (0.001 inch) from each other. The refiner is fitted with a conventional screw feeder and fitted with piping to provide a nominal 9 liters per minute process water flow through the feeder to the refiner housing where nominal 3.175 mm (1/8 inch)pellets of Teflon® PFA* resin are fed to the screw feeder at a rate of 11.3-22.7 kg (25-50 pounds) per hour, the refiner motor load is monitored to limit the feed rate by manual means to limit the motor load to 30% (motor idle load is 24%). The resultant refined thermoplastic fluoropolymer pulp of film-like flakes discharging from the refiner is collected on a 100 mesh screen. The size distribution of film-like flakes ranged from 50 to 700 microns in length/width with an average of approximately 250 microns, and the thickness of the film-like flakes as measured by cross-sectional photomicrographs was less than 0.1 times the average length/width dimension. Photomicrographic inspection showed the individual flakes, irregular in planar dimension, with microfibrals extending from the edges. The film-like flakes were observed to disperse easily in water with hand stirring.

### Example 2

This example is prepared on a paper machine as represented by Fig. 3. More particularly, a 567,8 l (150 gallon) total capacity Bird Pulper 10 is filled to two-thirds capacity (416 l - 110 gallons) with deionized water. A quantity of Hercules Type 1815 wet dispersible, 6.35 mm (0.25 inch) cut length carbon fiber is added to the pulper and dispersed for 5 minutes at minimum agitation to obtain a uniform slurry dispersion. Disk refined Teflon® PFA* 340 flakes are added and dispersed with moderate agitation for two additional minutes to create a uniform co-dispersed slurry consisting of the carbon fiber and Teflon® PFA* material. The pulper slurry is pumped to a moderately agitated machine supply tank 12 and further diluted such that the consistency is approximately 0.25% by weight solids. The feed stock was then pumped via pump 13 to the headbox of a 30.5 cm (12 inch) Bruderhaus inclined wire minipaper machine having a 45 degree incline on the forming wire 19. The stock is diluted at the headbox 16 to a consistency of 0.05% using water from tank 15. The headbox stock is deposited into the forming wire 19 in the usual manner and dewatered by passing over suction slots 18. The wire speed is 1.5 m/min (5 fpm) and the resulting sheet was captured on a take-up roll 20 in damp form as a blended sheet of carbon fiber and PFA, being easily transferred without fiber/resin distribution disruption. The sheet was then laid out in layers 17 and air dried to ambient moisture level. The dry sheet weight was approximately 0.244 kp/cm² (0.05 pounds per square foot).

### Example 3

A sheet from the product made according to Example 2 was layered on a plate covered with Kapton® film making a 0.6 m x 0.6 m (2' x 2') stack 3 ply deep. The plate was put into a heated platen press at 121°C (250°F) to dry for over 4 hours. The dried stack was subsequently preconsolidated into a sheet by sandwiching between Kapton® and steel plates and pressing.

A cycle of preheat at contact pressure for 15 minutes at 371°C (700°F) is followed by 30 minutes at 200 ton force at 371°C (700°F). The stack was then transferred to a cold press and cooled under pressure of 200 tons to form a solid preconsolidated sheet.

The preconsolidated sheet was cut into 7.6 x 15.2 cm (3" x 6") pieces and put into a 7.6 x 15.2 cm (3" x 6") "picture frame mold" to mold a 15.24 mm (0.6") thick block. The mold was heated under contact pressure in a press heated to 360°C (680°F) until the mold reached 349°C (660°F), then held under 3445 kPa (500 psi) for 20 minutes and cooled in place under pressure.

The properties of the block were:

| Flex Mod | | Flex Strength | | Flatwise Compression | |
|---|---|---|---|---|---|
| (MPa) | (Ksi)* | (kPa) | (Psi)* | (kPa) | (Psi)** |
| 10,300.5 | (1,495) | 123,229 | (17,904) | 201,009 | (29,174) |
| 9,949.2 | (1,444) | 121,830 | (17,741) | 196,530 | (28,524) |
| 10,093.9 | (1,465) | 127,872 | (18,559) | 193,643 | (28,105) |
| 10,114.5 | (1,468) | 124,489 | (18,068) | 197,102 | (28,607) |
| The block had a density of 2.035 grams/cm³. | | | | | |

| | | | | | |
|---|---|---|---|---|---|
| * measured per ASTM D790 using 12.7 x 152.2 x 3.18 mm thick bars (1/2" x 6" x 1/8") | | | | | |
| ** measured per ASTM C-365-57 using 25.4 x 25.4 x 15.24 mm (1" x 1" x 0.6") thick specimens | | | | | |

## Claims

1. A process for the production of a fluoropolymer-fiber composite comprising:
(a) co-dispersing fluoropolymer film-like flakes having an irregular periphery with microfibrils extending therefrom with fibers in an aqueous solution in the absence of organic solvents and emulsifying agents to form a homogenous slurry;
(b) feeding the slurry to a screen in a layer;
(c) removing water from the layer;
(d) drying the layer to form a self-supporting porous preform layer;
(e) preconsolidating said preform by heating said preform layer to above the melt temperature of the fluoropolymer, then applying sufficient pressure normal to the plane of the preform layer to cause the fluoropolymer to flow to form a solid preconsolidated sheet;
(f) cooling said sheet; and
(g) forming a solid shaped composite from a stack of said sheets by heating said stack to a high enough temperature and applying sufficient pressure for a sufficient amount of time to form said solid shaped composite.

2. The process as defined in claim 1, wherein said fluoropolymer is thermoplastic and said fiber is carbon fiber.

3. A melt flowable fluoropolymer thermoplastic material comprising: a plurality of flakes having an irregular shaped periphery with microfibrils extending therefrom, said flakes having a size distribution of from 50 to 700 microns, the fluoropolymer containing at least about 10% fluorine by weight, preferably at least about 45% fluorine by weight, especially preferred if the polymer is perfluorinated, i.e., containing essentially no hydrogen or halogen other than fluorine bound to carbon.

## Patentansprüche

1. Verfahren zur Herstellung eines Fluorpolymer-Faser-Verbundstoffes, umfassend:
(a) das Co-Dispergieren von folienartigen Fluorpolymerflocken, die eine unregelmäßige Peripherie mit davon abstehenden Mikrofibrillen aufweisen, mit Fasern in einer wäßrigen Lösung in Abwesenheit von organischen Lösungsmitteln und Emulgierungsmitteln unter Bildung einer homogenen Aufschlämmung;
(b) das Aufbringen der Aufschlämmung auf ein Sieb in einer Schicht;
(c) das Entfernen des Wassers aus der Schicht;
(d) das Trocknen der Schicht unter Herstellung einer selbsttragenden, porösen Vorformschicht;
(e) das Vorverfestigen der genannten Vorform durch Erhitzen der genannten Vorformschicht auf oberhalb der Schmelztemperatur des Fluorpolymeren, das anschließende Aufbringen von ausreichendem Druck senkrecht zur Ebene der Vorformschicht, um das Fluorpolymere zum Fließen zu bringen, unter Bildung eines festen vorverfestigten Flächengebildes;
(f) Abkühlen des genannten Flächengebildes; und
(g) das Herstellen eines festen geformten Verbundstoffes aus einem Stapel der genannten Flächengebilde durch Erhitzen des genannten Stapels auf eine ausreichend hohe Temperatur und das Aufbringen von ausreichendem Druck für eine ausreichende Zeitspanne zur Herstellung des genannten festen geformten Verbundstoffes.

2. Verfahren nach Anspruch 1, bei welchem das genannte Fluorpolymere thermoplastisch ist und die genannte Faser Kohlenstoffaser ist.

3. Schmelzfließbares thermoplastisches Fluorpolymermaterial, umfassend: eine Mehrzahl von Flocken, die eine unregelmäßig geformte Peripherie mit davon abstehenden Mikrofibrillen besitzen, wobei die genannten Flocken eine Größenverteilung von 50 bis 700 Mikron aufweisen, das Fluorpolymere wenigstens etwa 10 Gew.-% Fluor, vorzugsweise wenigstens etwa 45 Gew.-% Fluor, enthält, wobei das Polymere in besonders bevorzugter Weise perfluoriert ist, d.h. im wesentlichen keinen Wasserstoff oder anderes Halogen als Fluor an Kohlenstoff gebunden enthält.

## Revendications

1. Procédé de production d'un composite de fibres et de fluoropolymère comprenant:
(a) la codispersion de flocons de fluoropolymère, ayant la forme d'un film, présentant une périphérie irrégulière d'où partent des microfibrilles, avec des fibres dans une solution aqueuse en l'absence de solvants organiques et d'agents émulsifiants pour former une suspension épaisse homogène:
(b) l'alimentation de la suspension épaisse à un tamis en une couche;
(c) le retrait de l'eau de la couche;
(d) le séchage de la couche pour former une couche de préforme poreuse auto-porteuse;
(e) la préconsolidation de ladite préforme en chauffant ladite couche de préforme au-dessus de la température de fusion du fluoropolymère, en appliquant ensuite une pression suffisante perpendiculaire au plan de la couche de préforme pour entraîner le fluoropolymère à s'écouler de sorte à former une feuille préconsolidée solide;
(f) le refroidissement de ladite feuille; et
(g) la formation d'un composite façonné solide à partir d'un empilage desdites feuilles en chauffant ledit empilage à une température suffisamment élevée et en appliquant une pression suffisante pendant une durée suffisante pour former ledit composite façonné solide.

2. Procédé suivant la revendication 1, dans lequel ledit fluoropolymère est thermoplastique et ladite fibre est une fibre de carbone.

3. Matériau de fluoropolymère thermoplastique pouvant s'écouler à l'état fondu comprenant: une pluralité de flocons présentant une périphérie à forme irrégulière d'où partent des microfibrilles, lesdits flocons ayant une distribution de taille allant de 50 à 700 microns, le fluoropolymère contenant au moins environ 10% en poids de fluor, de préférence au moins environ 45% en poids de fluor, il est spécialement préféré si le polymère est perfluoré, c'est-à-dire, s'il ne contient essentiellement ni hydrogène, ni halogène autre que le fluor, lié au carbone.
